Europäisches Patentamt

European Patent Office

Office européen des brevets

(11) Publication number: **0 619 382 A1**

# EUROPEAN PATENT APPLICATION

(21) Application number: **93113218.7**

(22) Date of filing: **18.08.93**

(51) Int. Cl.5: **C23C 16/26**, C04B 41/50, B23B 27/14

(30) Priority: **09.04.93 JP 83437/93**

(43) Date of publication of application:
**12.10.94 Bulletin 94/41**

(84) Designated Contracting States:
**DE ES FR GB IT**

(71) Applicant: **Sumitomo Electric Industries, Ltd.**
**5-33, Kitahama 4-chome, Chuo-ku**
**Osaka 541 (JP)**

(72) Inventor: **Nakai, Tetsuo, c/o Itami Works of**
**Sumitomo**
**Electric Ind., Ltd.,**
**1-1, Koayakita 1-chome**
**Itami-shi, Hyogo (JP)**
Inventor: **Nakamura, Tsutomu, c/o Itami Works**
of Sumitomo
**Electric Ind., Ltd.,**
**1-1, Koayakita 1-chome**
**Itami-shi, Hyogo (JP)**
Inventor: **Kanada, Yasuyuki, c/o Itami Works**
of Sumitomo
**Electric Ind., Ltd.,**
**1-1, Koayakita 1-chome**
**Itami-shi, Hyogo (JP)**

(74) Representative: **Herrmann-Trentepohl,**
**Werner, Dipl.-Ing.**
**Patentanwälte Herrmann-Trentepohl,**
**Kirschner, Grosse, Bockhorni & Partner**
**Forstenrieder Allee 59**
**D-81476 München (DE)**

(54) **Hard sintered tool and manufacturing method thereof.**

(57) A hard sintered tool according to the invention includes a sintered diamond base material (1) containing 85-98% by volume of diamond grains having a mean grain size in the range from 0.1 to 10μm, 1-14% by volume of voids, and 0.05-3% by volume of an iron family metal or at least one kind of carbides of W, Ti, Ta, and Mo, and having a thickness in the range from 100 to 1000μm; a vapor phase synthesized diamond layer (5) formed on the top surface of the sintered diamond base material (1) and having a thickness in the range from 10 to 100μm; and a shank (7) joined to the bottom surface of the sintered diamond base material (1). In the above-described construction, a hard sintered tool having high strength and resistance to abrasion and heat can be provided.

FIG. 7

BACKGROUND OF THE INVENTION

Field of the Invention

The present invention relates to hard sintered tools and manufacturing methods thereof, and more specifically, to highly strong and resistant to abrasion and heat, sintered tools and a manufacturing method thereof.

Description of the Background Art

Conventionally, techniques using sintered diamond as a tool material have been known. One example of such technique using sintered diamond for tool material is disclosed in Japanese Patent Laying-Open No. 63-185859. Japanese Patent Laying-Open No. 63-185859 discloses sintered diamond having its surface coated with diamond. Thus coating the sintered diamond with diamond prevents cracks from being generated and a tool material having high resistance to abrasion can be provided.

The sintered diamond disclosed in Japanese Patent Laying-Open No. 63-185859 is however encountered with the following disadvantage.

Japanese Patent Laying-Open No. 63-185859 uses SiC, metal, or the like as a binding material for the sintered diamond. The strength of the resultant sintered diamond is enhaunced by using a metal such as cobalt (Co) for the binding material rather than SiC. It would therefore be desirable to use a metal such as Co as a binding material for sintered diamond.

In Japanese Patent Laying-Open No. 63-185859, when a metal is used as a binding material for sintered diamond, the metal on the surface of the sintered diamond is removed using aqua regia. The metal of the binding material is therefore left inside the sintered diamond. Accordingly, the sintered diamond contains a relatively large amount of metal components of binding material inside thereof.

Thus containing a relatively large amount of binding material-derived metal inside, the heat resistance of the sintered diamond deteriorates in heat resistance. More specifically, when the sintered diamond is exposed to a high temperature in producing vapor-synthesized diamond, for example, the sintered diamond is likely to deteriorate.

In view of such issue of heat resistance, the inventors disclose in Japanese Patent Laying-Open No. 64-21076 an application of the structure of sintered diamond and a diamond layer coating the diamond to a bonding tool which is a abrasive-resisting tool. The hard heat resisting sintered diamond disclosed in Japanese Patent Laying-Open No. 64-21076 can be used as a general cutting tool. The present invention is directed to great improvement of performance compared to conventional techniques by further optimizing the structure.

SUMMARY OF THE INVENTION

It is an object of the invention to provide a hard sintered tool strong and highly resistant to abrasion and heat, and a manufacturing method thereof.

A hard sintered tool according to the invention includes a cutting edge tip including a sintered diamond base material and a vapor phase synthesized diamond layer, and a shank. The sintered diamond base material contains 85-98% by volume of diamond grain having a mean grain diameter of 0.1-10$\mu$m, 1-14% by volume of voids, 0.05-3% by volume of an iron family metal or at least one kind of carbides of W, Ti, Ta, and Mo, and a thickness in the range from 100 to 1000$\mu$m. The vapor phase synthesized diamond layer is formed on the top surface of the sintered diamond base material. The thickness of the vapor phase synthesized diamond layer is about in the range from 10 to 100$\mu$m. The shank is joined with the bottom surface of the sintered diamond base material.

The thickness of the above-described vapor phase synthesized diamond is preferably larger than 20$\mu$m and at most 100$\mu$m. The surface roughness (Rmax) of the vapor phase synthesized diamond layer is preferably at most 0.5$\mu$m. The surface roughness (Rmax) of the flank of the hard sintered tool is preferably at most 0.5$\mu$m. Further, the cutting edge of the hard sintered tool is preferably worked with a laser beam. The surface roughness (Rmax) of the top surface of the sintered diamond base material is preferably at most 1$\mu$m.

Now, the significance of limitations in the structure of the above-described hard sintered tool will be described.

The thickness of the sintered diamond base material is in the range from 100 to 1000 $\mu$m. A sintered diamond base material having a thickness smaller than 100$\mu$m lacks strength as a base material. Meanwhile there will be no problem in terms of performance even if the thickness of the sintered diamond base material is larger than 1000 $\mu$m.

In such a case, however, the cost for the base material and working increases, a prolonged time period will be necessary for acid pickling process according to the present invention. Therefore, a thickness larger than 1000 $\mu$m would not be economically preferable. In view of the foregoing, the thickness of the sintered diamond base material is limited to a range from 100$\mu$m to 1000$\mu$m. From technological point of view, however, the thickness of the sintered diamond base material may be larger than 1000$\mu$m.

The mean diameter of diamond grain contained in the sintered diamond base material (hereinafter referred to simply as "grain size of diamond grain") is in the range from 0.1 to 10$\mu$m. The strength of sintered diamond greatly depends on the grain size of diamond grain contained in the sintered diamond.

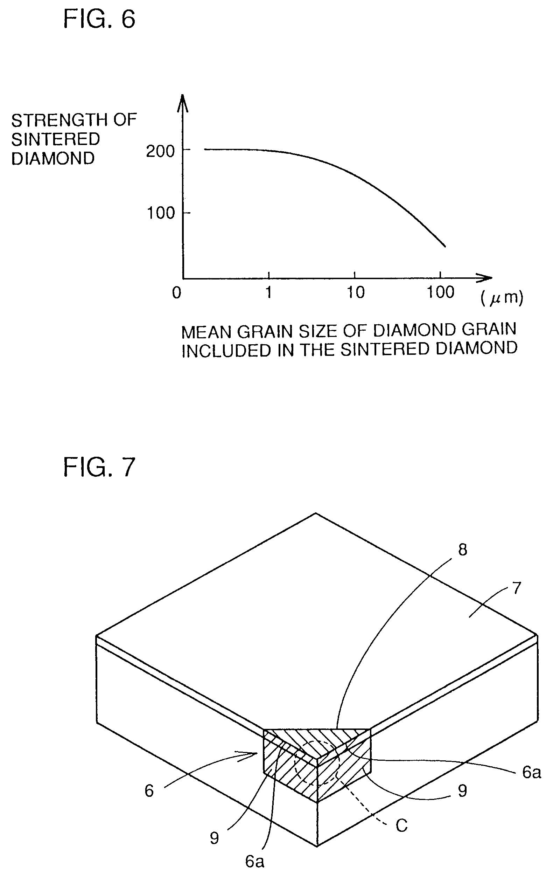

Fig. 6 is a representation showing the relation between the strength of sintered diamond and the grain size of diamond grain contained in the sintered diamond. As illustrated in Fig. 6, as the grain size of diamond grain included in the sintered diamond decreases, the strength of the sintered diamond increases.

If, however, the grain size of diamond grain contained in the sintered diamond base material is smaller than 0.1$\mu$m, fine diamond grain grows at the time of sintering under an extra high pressure. Accordingly, a desired sintered diamond base material cannot be obtained. If the grain size of diamond grain included in a sintered diamond base material is in excess of 10$\mu$m, the strength of the sintered diamond base material degrade.

Vapor phase synthesized diamond formed on the surface of the sintered diamond base material grows with diamond grain in the sintered diamond being nucleus. Accordingly, if the grain size of diamond grain contained in the sintered diamond base material is large, the vapor phase synthesized diamond grain themselves become coarse As a result, when such base material is used for a tool, the cutting edge of the tool tends to be easily damaged. Therefore, the grain size of diamond grain contained in the sintered diamond base material is limited to a range from 0.1$\mu$m to 10$\mu$m.

The content of diamond grain in the sintered diamond base material is in the range from 85 to 98% by volume. If the content of diamond grain in a sintered diamond base material is smaller than 85% by volume, the amount of mutually bonded diamond grain is small. Therefore, the strength of the sintered diamond base material becomes low.

Manufacturing a sintered diamond base material containing diamond grain in excess of 98% by volume requires an extra high pressure above 70kb. This is not economically preferable. Therefore, the content of diamond grain in the sintered diamond base material is limited to a range from 85 to 98% by volume.

The amount of an iron family metal or at least one kind of material of carbides of W, Ti, Ta, and Mo contained in the sintered diamond base material is in the range from 0.05 to 3% by volume. The iron family metal is used for causing diamond grain contained in the sintered diamond base material to bond with each other in manufacturing the sintered diamond base material.

The carbide of W, Ti, Ta, or Mo is used for restraining growth of diamond grain in manufacturing a fine diamond sintered material. The content of each material described above in the sintered diamond base material is preferably as small as possible.

However, even if acid pickling treatment for a long period of time is performed to the sintered diamond containing the above-described material, each material enclosed in the part in which diamond grain bond with each other remains in the sintered diamond base material. Generally, this remaining amount is about 0.05% by volume.

If the amount of a material such as an iron family metal contained in a sintered diamond base material is in excess of 3% by volume, treatment of the sintered diamond base material at a high temperature graphitizes diamond, or causes cracks to be generated in the sintered diamond base material due to difference in thermal expansion between the diamond and the above-described material such as iron family metal.

More specifically, if a material such as an iron family metal described above is contained in an amount in excess of 3% by volume in the sintered diamond base material, the heat resistance of the sintered diamond base material degrades. Therefore, the amount of the iron family metal or at least one kind of carbides of W, Ti, Ta, and Mo contained in the sintered diamond base material is limited to about the range from 0.05 to 3% by volume.

Voids about in the range from 1 to 14% by volume are present in the sintered diamond base material. The amount of the voids is determined by the amount of diamonds in the sintered diamond base material, and the amount of the iron family metal or carbide of W, Ti, Ta, or Mo.

If the amount of voids contained in the sintered diamond base material is smaller than 1% by volume, the amount of the material such as iron family metal remaining in the sintered diamond base material after the acid pickling treatment is large. Accordingly, the thermal resistance of the sintered diamond base material degrades.

Assuming that the amount of voids contained in the sintered diamond base material is smaller than 1% by volume, the amount of diamond contained in the sintered diamond base material could be in excess of 98% by volume. In this case, the price of the sintered diamond base material will be high, which is disadvantageous in view of economical aspect.

If the content of voids included in a sintered diamond base material is in excess of 14% by volume, the strength of the sintered diamond base material degrade. In view of the foregoing, the amount of voids included in sintered diamond is limited to about the range from 1 to 14% by volume.

The thickness of the vapor phase synthesized diamond layer is about in the range from 10 to 100$\mu$m. If the thickness of the vapor phase synthesized diamond layer is smaller than 10$\mu$m, the high resistance of the vapor phase synthesized diamond layer to abrasion can not be demonstrated. If the thickness of the vapor phase synthesized diamond layer is in excess of 100$\mu$m, the vapor phase synthesized diamond layer growing on the surface of the sintered diamond base material develops to columnar crystals. Accordingly, the cutting edge of the resultant hard sintered tool tends easily to chip.

Therefore, the thickness of the vapor phase synthesized diamond layer is limited to about in the range from 10$\mu$m to 100$\mu$m. More preferably, the thickness of the vapor phase synthesized diamond layer is in excess of about 20$\mu$m. Thus sufficient abrasion resistance is demonstrated.

The surface roughness (Rmax) of the vapor phase synthesized diamond layer is preferably at most 0.5$\mu$m. Part of the surface of the vapor phase synthesized diamond layer constitutes a rake face in the hard sintered tool. If the surface roughness of the rake face is in excess of 0.5$\mu$m, a workpiece tends to be more easily deposited to the surface of the rake face. This creates the following disadvantage. Thus cutting resistance at the time of cutting fluctuates. The surface roughness of a resultant workpiece degrades due to formation of a built-up edge. Therefore, the surface roughness (Rmax) of the vapor phase synthesized diamond layer is preferably at most 0.5$\mu$m.

The surface roughness (Rmax) of the flank of the hard sintered tool is at most 0.5$\mu$m.

In cutting, the shape of the cutting edge of a tool is transferred onto the surface of a workpiece. Therefore, if the roughness of the flank of the tool is in excess of 0.5$\mu$m, the surface roughness of a workpiece becomes large. Therefore, the surface roughness (Rmax) of the blank of the hard sintered tool is preferably at most 0.5$\mu$m.

The surface roughness (Rmax) of the top surface of the sintered diamond base material is preferably at most 1$\mu$m. A vapor phase synthesized diamond layer is formed on the top surface of the sintered diamond base material. If the vapor phase synthesized diamond layer is grown on the top surface of the sintered diamond base material, the surface roughness of the vapor phase synthesized diamond layer becomes larger than the roughness of the top surface of the sintered diamond base material.

Accordingly, keeping the surface roughness of the top surface of the sintered diamond base material as small as possible will be advantageous in working the surface of the vapor phase synthesized diamond layer. Accordingly, it is pointed out that the surface roughness (Rmax) of the top surface of the sintered diamond base material is preferably at most 1$\mu$m.

According to a method of manufacturing a hard sintered tool of the present invention, 85-98% by volume of diamond grain having a mean grain size in the range from 0.1 to 10$\mu$m with remaining part being constituted by 2-15% by volume of an iron metal or at least one kind of carbides of W, Ti, Ta, and Mo is formed at least 50000 atm at a temperature of at least 1300°C. Acid pickling treatment of the sintered diamond base material elutes 1-14% by volume of the iron family metal or the carbide of W, Ti, Ta, or Mo. A vapor phase synthesized diamond layer is formed on the top surface of the sintered diamond base material by means of vapor phase synthesization. Then, the bottom surface of the sintered diamond base material is joined to a shank.

The above-described vapor phase synthesized diamond layer is preferably formed after working the top surface of the sintered diamond base material to attain a surface roughness (Rmax) smaller than 1$\mu$m. The cutting edge of the hard sintered tool is preferably worked with a laser beam after joining the bottom surface of the sintered diamond base material to the shank.

According to a method of manufacturing a hard sintered tool of the present invention, acid pickling treatment of the sintered diamond base material elutes 1-14% by volume of the iron family metal or the carbide of W, Ti, Ta, or Mo. Thus, 1-14% by volume of voids can be formed in the sintered diamond base material. Thus, the heat resistance of the sintered diamond base material can be improved.

According to the method of manufacturing a hard sintered tool of the present invention, the vapor phase synthesized diamond layer is formed after working the top surface of the sintered diamond base material so that the surface roughness (Rmax) of the top surface of the sintered diamond base material becomes at most 1$\mu$m. Accordingly, the surface roughness of the vapor phase synthesized diamond layer immediately after forming thereof on the top surface of the sintered diamond base material can be restricted to a relatively small level. Consequently, working process such as polishing of the surface of the vapor phase synthesized diamond layer will be easy.

According to the method of manufacturing a hard sintered tool of the present invention, the cutting edge of the hard sintered tool is worked with a laser beam. Since diamond has a high hardness, usually a diamond grindstone must be used for mechanical working of the diamond. In such a case, however, the diamond and the grindstone are mutually ground and therefore working efficiency is low. In mechanical working, drop out diamond grains appear at the formed cutting edge. Therefore, a sharp cutting edge can be hardly obtained.

In contrast, if diamond is thermally worked with a laser beam or the like, the working can be performed at a low cost. Furthermore, since mechanical load is not imposed, diamond grain does not drop out. Accordingly, a highly sharp cutting edge can be formed. This method is disclosed in Japanese Patent Laying-Open No. 4-146007. However, application of the present invention to this method can further improve its performance. In this case, however, the heat resistance of diamond must be secured.

A hard sintered tool according to the present invention has a high heat resistance, and therefore the material of the tool does not deteriorate due to thermal working using a laser beam or the like. Therefore, the cutting edge of the hard sintered tool can be worked at a low cost with a high quality.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1A is a perspective view showing a diamond sintered body in a first step in a manufacturing process of a hard sintered tool according to the present invention;

Fig. 1B is a view showing the B region in Fig. 1A being expended;

Fig. 2A is a perspective view showing the diamond sintered body in a second step in the manufacturing process of a hard sintered tool according to the present invention;

Fig. 2B is a view showing the B region in Fig. 2A being expanded;

Fig. 3 is a perspective view showing the diamond sintered body in a third step in the manufacturing process of a hard sintered tool according to the present invention;

Fig. 4 is a perspective view showing a diamond sintered body in a fourth step in the manufacturing process of a hard sintered tool according to the present invention;

Fig. 5A is a perspective view showing a diamond sintered body in a fifth step in the manufacturing process of a hard sintered tool according to the present invention;

Fig. 5B is a partial plan view of Fig. 5A;

Fig. 6 is a representation showing the relation between the strength of sintered diamond and the mean grain size of diamond grain included in the sintered diamond; and

Fig. 7 is a perspective view showing one example of a hard sintered tool formed according to the present invention.

DESCRIPTION OF THE PREFERRED EMBODIMENTS

Now, embodiments of the present invention will be described in conjunction with the accompanying drawings.

(First Embodiment)

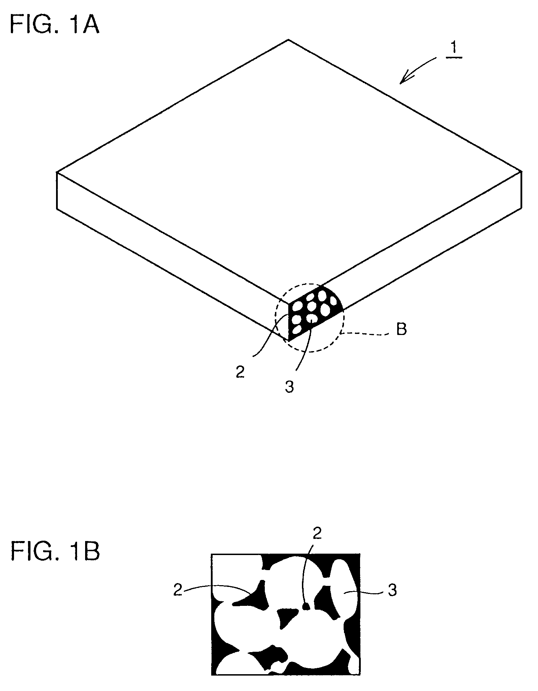

Figs. 1-5 are views showing 1st-5th steps in a method of manufacturing a hard sintered tool according to the present invention. Referring to Figs. 1-5 from time to time, the method of manufacturing a hard sintered tool will be described.

Table 1 shows the compositions of diamond sintered bodies each for a base material.

Table 1

| Diamond Sintered Body (No.) | Composition of Diamond Sintered Body (Vol. %) | Grain Size of Diamond Grain (μm) | Content of Iron Family Metal After Acid Pickling (Vol. %) | Voids (Vol. %) |
|---|---|---|---|---|
| 1 | Co:7, W:2, diamond 91 | 0.5-2μm | 0.06 | 8.94 |
| 2 | Co:7, W:2, diamond 91 | 0.5-2μm | 0.5 | 8.5 |
| 3 | Co:7, W:2, diamond 91 | 0.5-2μm | 1.3 | 7.3 |
| 4 | Co:7, W:2, diamond 91 | 0.5-2μm | 2.8 | 6.2 |
| 5 | Co:7, W:2, diamond 91 | 0.5-2μm | 4.3 | 4.7 |
| 6 | Co:5.5, Ti:1.5, diamond 93 | 10-20μm | 1.3 | 5.7 |
| 7 | Co:5.5, Ti:1.5, diamond 93 | 30-40μm | 2.8 | 4.2 |
| 8 | Co:7, W:4, Ta:3, Mo:3.5, diamond 82.5 | 0.5-2μm | 0.06 | 17.44 |
| 9 | Co:7, W:4, Ta:3, Mo:3.5, diamond 82.5 | 0.5-2μm | 1.8 | 15.7 |

The diamond sintered bodies having compositions shown in Table 1 are manufactured at an extra high pressure and at a high temperature (60000 atm, 1600°C). Then, each diamond sintered body is cut into a shape of 2.0x20x0.3mm. This is shown in Figs. 1A and 1B. The B region in Fig. 1A is shown and expanded in Fig. 1B. Referring to Fig. 1B, diamond sintered body 1 immediately after sintering has diamond grain parts 3 bonded with each other, and binder parts 2 present between diamond grain parts 3.

6

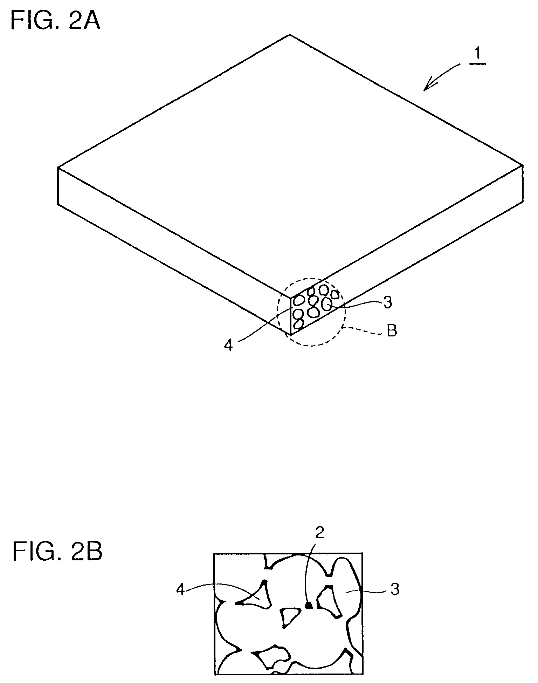

Each diamond sintered body after sintering set forth in Table 1 is soaked in hot aqua regia. Thus, an iron family metal and/or carbides of W, Ti, Ta, Mo is eluted. This is shown in Figs. 2A and 2B. Fig. 2A is a perspective view showing diamond sintered body 1 after acid pickling treatment. Fig. 2B is a view showing the B region in Fig. 2A being expanded.

Referring to Figs. 2A and 2B, voids 4 are formed in diamond sintered body 1 after the acid pickling treatment. A small amount of binder 2 however remains between diamond grain 3 at the time.

The iron family metal component remaining in the diamond sintered body subjected to the acid pickling treatment described above is measured using a magnetic balance. In Table 1, the amount of the iron family metal component and the amount of voids 4 included in each diamond sintered body after acid pickling treatment are shown.

Now, the surface of the diamond sintered body is worked and its surface roughness (Rmax) becomes at most $1\mu$m. Then, a hard diamond coating (hereinafter referred to as "vapor phase synthesized diamond layer") is produced on the surface of the diamond sintered body. As one approach therefor, a thermal filament CVD (Chemical Vapor Deposition) process is employed. Conditions for the process are set forth below.

| Material gas (flow rate) | $H_2$ 210 sccm<br>$CH_4$ 10 sccm |
|---|---|
| Gas pressure<br>Filament temperature<br>Filament-substrate distance<br>Substrate temperature | 100 torr<br>2150°C<br>5.5mm<br>915°C |

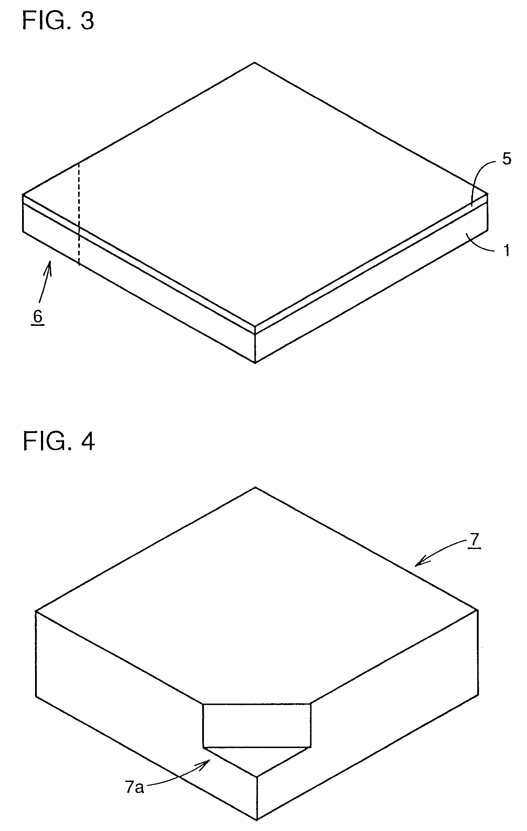

Under the above-described conditions, synthesization is performed for 50 hours. Thus, as illustrated in Fig. 3, a vapor phase synthesized diamond layer 5 is formed on the surface of diamond sintered body 1. The thicknesses of vapor phase synthesized diamond layers 5 after the synthesization for 50 hours as described above are set forth in Table 2.

Table 2

| Diamond Sintered Body (No.) | Thickness of Vapor Phase Synthesized Diamond Layer | Thickness of Vapor phase Synthesized Diamond Layer After Wrapping Working | Growing Grain size of Vapor Phase Synthesized Diamond Layer |
|---|---|---|---|
| 1 | $55\mu$m | $31\mu$m | $8$-$10\mu$m |
| 2 | $52\mu$m | $32\mu$m | $8$-$10\mu$m |
| 3 | $49\mu$m | $30\mu$m | $8$-$10\mu$m |
| 4 | $43\mu$m | $32\mu$m | $8$-$10\mu$m |
| 5 | diamond sintered body broken | - | - |
| 6 | $60\mu$m | $33\mu$m | $33$-$51\mu$m |
| 7 | $52\mu$m | $31\mu$m | $60$-$90\mu$m |
| 8 | $50\mu$m | $32\mu$m | $8$-$10\mu$m |
| 9 | $51\mu$m | $33\mu$m | $8$-$10\mu$m |

Referring to Fig. 2, diamond sintered body No. 5 containing a large amount of residue iron family metal was broken due to thermal deterioration when vapor phase synthesized diamond layer 5 is formed. The other diamond sintered bodies are each worked into a mirror surface having a surface roughness (Rmax) of $0.04\mu$m by performing a wrapping treatment to the surface of vapor phase synthesized diamond layer 5. Note that the thickness of vapor phase synthesized diamond layer 5 after the wrapping working is also set forth in Table 2.

7

As in the foregoing, diamond sintered body 1 with vapor phase synthesized diamond layer 5 being formed on its surface is cut into a desired shape. This is illustrated in Fig. 3. Diamond sintered body 1 and vapor phase synthesized diamond layer 5 are cut using a YAG laser. Thus, a cutting edge tip 6 shown in Fig. 3 is formed.

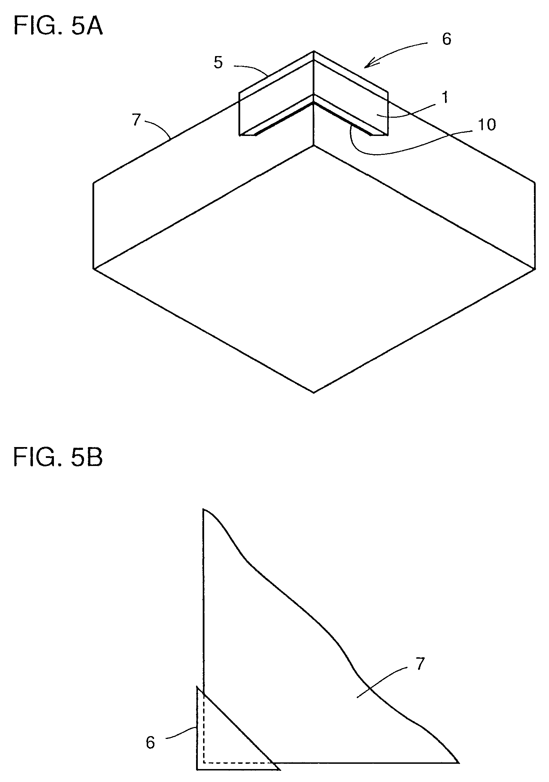

Then, vapor phase synthesized diamond layer 5 is thermally joined to a shank of cemented carbide in a vacuum atmosphere using a brazing material containing Ag-65%, Cu-32.7%, and Ti-2.3% so that the surface of vapor phase synthesized diamond layer 5 after the wrapping treatment becomes the rake face of the tool. This is shown in Figs. 4 and 5. Fig. 4 is a perspective view showing shank 7 having a setting portion 7a for cutting edge tip 6. The above-described cutting edge tip 6 is mounted at cutting edge tip setting portion 7a at shank 7.

Fig. 5A shows the state in which shank 7 is joined to cutting edge tip 6. Referring to Fig. 5A, the bottom surface of cutting edge tip 6 (the bottom surface of diamond sintered body) is joined to the cutting edge tip setting portion 7a of shank 7 with brazing material 10 therebetween. Fig. 5B is a partial plan view showing the state immediately after joining cutting edge tip 6 to shank 7. Referring to Fig. 5B, cutting edge tip 6 is joined to shank 7 so that the side surface of cutting edge tip 6 projects from the side of shank 7. Then, the cutting edge portion of the tool is formed by performing laser working. Going through the above-described process, the hard sintered tool is completed.

Fig. 7 shows one example of a hard sintered tool after working of cutting edge portion 6a. Referring to Fig. 7, working for forming cutting edge portion 6a forms the flank 9 of the hard sintered tool. Flank 9 is worked to attain a surface roughness (Rmax) of 0.5$\mu$m or smaller.

A partial surface 8 of vapor phase synthesized diamond layer 5 constitutes the rake face 8 of the hard sintered tool. The working is conducted so that the surface roughness (Rmax) of rake face 8 becomes 0.5$\mu$m or smaller.

Note that the cutting edge of the hard sintered tool can be interpreted as the entire cutting edge tip 6 or, as illustrated in Fig. 7, can be interpreted as the tip end regions C of cutting edge tip 6.

The performance of hard sintered tools (diamond tools) obtained going through the above-described process were evaluated under the conditions as follows. At the time, a sintered diamond tool having a diamond grain size of 10$\mu$m and containing 12% by volume of Co as binder is manufactured as well. The performance of the sintered diamond tool is evaluated in the same manner.

(Cutting Conditions)

| Workpiece | A390-T6 (A1-17%Si) rod |
|---|---|
| Cutting speed | 600m/min |
| Cutting amount | 0.5mm |
| Feeding amount | 0.2mm/rev |
| Cutting liquid | water soluble oil agent |

The result of performance evaluation described above is set forth in Table 3.

Table 3

| Diamond Tool (No.) | Abrasion Amount of Tool Flank | | |
|---|---|---|---|
| | after 5 min. cutting | after 10 min. cutting | after 15 min. cutting |
| 1 | 19$\mu$m | 45$\mu$m | 58$\mu$m |
| 2 | 20$\mu$m | 43$\mu$m | 55$\mu$m |
| 3 | 18$\mu$m | 44$\mu$m | 52$\mu$m |
| 4 | 29$\mu$m | 57$\mu$m | 77$\mu$m |
| 5 | - | - | - |
| 6 | 35$\mu$m | 65$\mu$m | broken |
| 7 | 50$\mu$m | broken | |
| 8 | broken | | |
| 9 | broken | | |
| Sintered Diamond Tool | 33$\mu$m | 61$\mu$m | 88$\mu$m |

Referring to Table 3, diamond tools No. 6 and No. 7 each having a large growing grain size in the vapor phase synthesized diamond layer broke after chippings were observed at their cutting edges. Meanwhile, diamond tools No. 8 and No. 9 having a small content of diamond broke in an early stage of cutting, because the strength greatly deteriorated after acid pickling.

In contrast, diamond tools No. 1, No. 2, No. 3, and No. 4 according to the present invention did not break. More specifically, it was demonstrated that these diamond tools have higher resistance to abrasion than the sintered diamond tool.

(Second Embodiment)

A second embodiment of the present invention will be described. As in the case of First Embodiment, a vapor phase synthesized diamond layer was formed on each of diamond sintered bodies manufactured under an extra high pressure at a high temperature. The cutting performance of tools formed of these materials was evaluated. The composition of each diamond sintered body manufactured at an extra high pressure at a high temperature is set forth in Table 4.

Table 4

| Diamond Sintered Body | Composition of Diamond Sintered Body (Vol. %) | Thickness of Diamond Sintered Body |
|---|---|---|
| A | Co:9, W:2, Ti:1, Ta:0.5, Diamond 87.5 | 0.07mm |
| B | Co:9, W:2, Ti:1, Ta:0.5, Diamond 87.5 | 0.15mm |
| C | Co:9, W:2, Ti:1, Ta:0.5, Diamond 87.5 | 0.35mm |

The grain size of diamond included in each diamond sintered body used is in the range from 1 to 2$\mu$m. Each diamond sintered body is cut into a shape of $\phi$25mm after sintering. The thickness of diamond sintered body at the time is set forth in Table 4.

Then, each diamond sintered body is soaked in hot aqua regia. Thus, iron family metal carbides of, W, Ti, or Ta were eluted from each diamond sintered body. At the time, the iron family metal component remaining in each diamond sintered body measured by a magnetic balance was 2.5%.

A vapor phase synthesized diamond layer was formed on the surface of each diamond sintered body by means of microwave plasma chemical vapor deposition. The conditions for synthesization are set forth below.

| Material gas (flow rate) | H$_2$ 200 sccm |
| | CH$_4$ 15 sccm |
| Gas pressure | 120 torr |
| Microwave transmission power | 620W |

Under the above-described conditions, the vapor phase synthesized diamond layer was formed on the surface of each diamond sintered body with synthesization time varying among 8, 25, 60, and 105 hours. A wrapping working was performed on the surface of the vapor phase synthesized diamond layer. The thickness of each vapor phase synthesized diamond layer, the thickness of each vapor phase synthesized diamond layer after the wrapping working, and the growing grain size of each vapor phase diamond layer are set forth in Table 5.

Table 5

| Diamond Sintered Body | Thickness of Diamond Sintered Body | Thickness of Vapor-Phase Synthesized Diamond Layer | Thickness of Vapor-Phase Synthesized Diamond Layer After Wrapping Working | Growing Grain Size of Vapor-Phase Synthesized Diamond Layer |
|---|---|---|---|---|
| A-1 | 0.07mm | 13$\mu$m | 8$\mu$m | 3-5$\mu$m |
| A-2 | 0.07mm | 29$\mu$m | 16$\mu$m | 5-8$\mu$m |
| A-3 | 0.07mm | 65$\mu$m | 49$\mu$m | 10-15$\mu$m |
| A-4 | 0.07mm | 121$\mu$m | 105$\mu$m | 35-51$\mu$m |
| B-1 | 0.15mm | 15$\mu$m | 7$\mu$m | 3-5$\mu$m |
| B-2 | 0.15mm | 27$\mu$m | 15$\mu$m | 5-8$\mu$m |
| B-3 | 0.15mm | 71$\mu$m | 50$\mu$m | 10-15$\mu$m |
| B-4 | 0.15mm | 123$\mu$m | 108$\mu$m | 35-51$\mu$m |
| C-1 | 0.35mm | 13$\mu$m | 8$\mu$m | 3-5$\mu$m |
| C-2 | 0.35mm | 31$\mu$m | 17$\mu$m | 5-8$\mu$m |
| C-3 | 0.35mm | 69$\mu$m | 47$\mu$m | 10-15$\mu$m |
| C-4 | 0.35mm | 122$\mu$m | 106$\mu$m | 35-51$\mu$m |

Thus obtained diamond sintered body having the vapor phase synthesized diamond layer on its surface was cut into a desired size for its use as a tool material. Thus, the tool material was formed. The bottom surface of the diamond sintered body in the tool material was thermally joined to the shank so that the surface of the vapor phase synthesized diamond layer after the wrapping treatment became a flank for the tool.

At the time, a brazing material containing Ag-65%, Cu-32.7%, and Ti-2.3% was used. The melting point of the brazing material is 830°C. Using the brazing material, the tool material was thermally joined to a cemented carbide shank in an argon atmosphere. Then, working was performed to form cutting edge portion 6a using a YAG laser and the tool was completed.

The performance of thus obtained diamond tool was evaluated under the conditions set forth below. At the same time, a tool formed of sintered diamond having the grain size of diamond contained therein being 15$\mu$m and containing 9% by volume of Co as a binder was manufactured. The manufactured tool was subject to the same performance evaluation.

(Cutting Conditions)

| Workpiece | aluminum silicon casting (Al-25%Si) 4U bar |
|---|---|
| Cutting speed | 600m/min |
| Cutting amount | 0.5mm |
| Feeding amount | 0.14mm/rev |
| Cutting liquid | dry |

The result of performance evaluation is set forth in Table 6.

Table 6

| Diamond Tool | Abrasion Amount of Tool Flank | | |
|---|---|---|---|
| | after 5 min. cutting | after 10 min. cutting | after 15 min. cutting |
| A-1 | broken | | |
| A-2 | broken | | |
| A-3 | broken | | |
| A-4 | broken | | |
| B-1 | 65$\mu$m | 135$\mu$m | 190$\mu$m |
| B-2 | 32$\mu$m | 75$\mu$m | 122$\mu$m |
| B-3 | 35$\mu$m | 58$\mu$m | 77$\mu$m |
| B-4 | chipping | broken | |
| C-1 | 77$\mu$m | 123$\mu$m | 201$\mu$m |
| C-2 | 29$\mu$m | 64$\mu$m | 113$\mu$m |
| C-3 | 30$\mu$m | 55$\mu$m | 79$\mu$m |
| C-4 | broken | | |
| sintered diamond tool | 41$\mu$m | 101$\mu$m | 145$\mu$m |

Since the thickness of the diamond tool material was small, diamond tools A-1, A-2, A-3, and A-4 all broke in early stages of cutting. This is because the diamond tool material was too thin to withstand.

Meanwhile, having a large growing grain size in the vapor phase synthesized diamond layer, B-4 and C-4 were prone to cleavage in crystal grains and therefore broke after chippings were generated at their cutting edges.

In contrast, it was demonstrated that diamond tools B-1, B-2, B-3, C-1, C-2, and C-3 have high resistance to abrasion and damage as compared to the sintered diamond tool.

(Third embodiment)

Now, a third embodiment of the invention will be described. As in the case of First Embodiment, a vapor phase synthesized diamond layer was formed on a diamond sintered body manufactured under an extra high pressure and at a high temperature. The cutting performance of the structure used as a tool material was evaluated. The composition of the diamond sintered body manufactured under an extra high pressure at a high temperature used in this test is as follows.

11

| Composition of diamond sintered body | Co-6.5%, W-1.5%, Ti-1%, Ta-0.5% |
|---|---|
| Grain size of diamond | 1-2μm |
| Thickness of diamond sintered body | 0.4mm |
| Residue iron family metal after acid pickling | 1.2% |

After an acid pickling treatment, the above-described diamond sintered body was cut into a dimension of 20x20x0.4mm. A vapor phase synthesized diamond layer was formed on the surface of the diamond sintered body thus cut into the prescribed shape, by means of thermal filament CVD. The conditions are set forth below.

| Material gas (flow rate) | H$_2$ 200 sccm |
|---|---|
| | CH$_4$ 12 sccm |
| Gas pressure | 120 torr |
| Filament temperature | 2020°C |
| Filament-substrate distance | 6.0mm |
| Substrate temperature | 930°C |

Under the above-described conditions, synthesization was performed for 50 hours. Thus, the vapor phase synthesized diamond layer having a thickness of 62μm was formed on the surface of the diamond sintered body.

Then, a wrapping working was performed to the surface of the vapor phase synthesized diamond layer. Time for the wrapping working varied among 0, 10, 30, and 50 hours. Thus obtained tool material was cutting to a prescribed size. The tool material was thermally joined to a cemented carbide shank so that the surface in the vapor phase synthesized diamond layer subjected to the above-described wrapping treatment was formed to be the rake face of the tool.

At the time, the above-described tool material was thermally joined onto the cemented carbide shank with a brazing material therebetween. The brazing material has a melting point of 790°C, and contains Ag-69%, Cu-22.5%, In-6%, and Ti-2.5%. The above-described thermal joining was performed in a vacuum atmosphere.

Then, the flank of the tool was subjected to a thermal working using a YAG laser beam and to a grinding working using a diamond grindstone having a different grain size to form a cutting edge portion 6a. The characteristics of thus obtained diamond tool are set forth in Table 7.

Table 7

| Diamond Tool | Wrapping Time (Hour) | Surface Roughness of Tool Rake face (Rmax) | Method of Forming Cutting Edge | Surface Roughness of Tool Flank (Rmax) |
|---|---|---|---|---|
| a | 50 | $0.05\mu m$ | YAG laser | $0.1\mu m$ |
| b | 50 | $0.05\mu m$ | #140 grindstone | $0.6\mu m$ |
| c | 50 | $0.05\mu m$ | #1500 grindstone | $0.2\mu m$ |
| d | 30 | $0.2\mu m$ | YGA laser | $0.1\mu m$ |
| e | 30 | $0.2\mu m$ | #140 grindstone | $0.6\mu m$ |
| f | 30 | $0.2\mu m$ | #1500 grindstone | $0.2\mu m$ |
| g | 10 | $0.7\mu m$ | YGA laser | $0.1\mu m$ |
| h | 10 | $0.7\mu m$ | #140 grindstone | $0.6\mu m$ |
| i | 10 | $0.7\mu m$ | #1500 grindstone | $0.2\mu m$ |
| j | not-worked | $17\mu m$ | YGA laser | $0.1\mu m$ |
| k | not-worked | $17\mu m$ | #140 grindstone | $0.6\mu m$ |
| l | not-worked | $17\mu m$ | #1500 grindstone | $0.2\mu m$ |

The cutting performance of thus obtained diamond tool was evaluated. Items for evaluation are the surface roughness of a finished work piece (Rmax), and the presence/absence of burr at end surfaces. Simultaneously, a tool material of sintered diamond having a diamond grain size of $5\mu m$ and containing 10% by volume of Co as a binder was manufactured . The same cutting performance evaluation was conducted to this tool material.

(Cutting Conditions)

| | |
|---|---|
| Work piece | ADC12 (Al-12%Si) rod |
| Cutting speed | 300m/min |
| Cutting amount | 0.2mm |
| Feeding amount | 0.1mm/rev |
| Cutting liquid | dry |

The result of cutting performance evaluation described above is set forth in Table 8.

13

Table 8

| Diamond Tool | Finished Surface Roughness | Burr |
| --- | --- | --- |
| a | 4.3μm | none |
| b | 8.3μm | none |
| c | 5.1mm | none |
| d | 4.4μm | none |
| e | 10.2μm | none |
| f | 4.9μm | none |
| g | deposition present | present |
| h | deposition present | present |
| i | deposition present | present |
| j | deposition present | present |
| k | deposition present | present |
| l | deposition present | present |
| sintered diamond tool | 6.1μm | none |

Part of the workpiece was deposited on the rake face of diamond tools g, h, i, j, k, and l having a large tool face (rake face) roughness. Therefore, the finished surface became rough with burr being observed. Meanwhile, no deposition was found in diamond tools b and e with a cutting edge formed using a coarse grindstone, because each tool face roughness was small. However, the large surface roughness of the flank was transferred onto the work piece and therefore the finished surface roughness degraded. On the other hand, diamond tools a, c, d, and f, having a small roughness of the rake face, having a cutting edge formed using a laser beam or a grindstone of small grain size each demonstrated high performance as a tool for finishing.

The hard sintered body according to the present invention described above can be used for cutting tools such as miller and lathe, rotating tools such as drill or the like.

As discussed above, according to the present invention, a hard sintered tool having high strength and resistance to abrasion as well as high heat resistance can be obtained. Thus, due to its high heat resistance, working with a laser beam is permitted. Accordingly, the manufacturing cost can be reduced and high performance as a finishing tool can be demonstrated.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A hard sintered tool comprising:

   a sintered diamond base material (1) containing 85-98% by volume of diamond grain having a mean grain size of 0.1-10μm, 1-14% by volume of voids, 0.05-3% by volume of an iron family metal or at least one kind of carbides of W, Ti, Ta, and Mo, and having a thickness in the range from 100 to 1000μm;

   a cutting edge tip (6) having a vapor phase synthesized diamond layer (5), formed on the top surface of said sintered diamond base material (1), with a thickness in the range from 10 to 100μm; and

   a shank (7) joined to the bottom surface of said sintered diamond base material (1).

2. A hard sintered tool as recited in claim 1, wherein

   the thickness of said vapor phase synthesized diamond layer (5) is larger than 20μm and at most 100μm.

14

**3.** A hard sintered tool as recited in claim 1, wherein
part of the surface of said vapor phase synthesized diamond layer (5) constitutes the rake face (8) of said hard sintered tool, and
the surface roughness (Rmax) of said vapor phase synthesized diamond layer (5) at the part to be said rake face (8) is at most 0.5$\mu$m.

**4.** A hard sintered tool as recited in claim 1, wherein
the surface roughness (Rmax) of the flank (9) of said hard sintered tool is at most 0.5$\mu$m.

**5.** A hard sintered tool as recited in claim 1, wherein
a cutting edge portion (6a) is formed with laser at the cutting edge tip of said hard sintered tool.

**6.** A hard sintered tool as recited in claim 1, wherein
the flank (9) of said hard sintered tool has a surface portion worked with laser.

**7.** A hard sintered tool as recited in claim 1, wherein
the surface roughness (Rmax) of the top surface of said sintered diamond base material (1) is at most 1$\mu$m.

**8.** A hard sintered tool as recited in claim 1, wherein
said sintered diamond base material (1) is joined to said shank (7) with a brazing material containing Ag, Cu, and Ti in prescribed amounts therebetween.

**9.** A method of manufacturing a hard sintered tool, comprising the steps of:
forming a sintered diamond base material (1) containing 85-98% by volume of diamond grains having a mean grain size in the range from 0.1 to 10$\mu$m, with 2-5% by volume of the remaining being selected from the group comsisting of an iron family metal and at least one kind of carbides of W, Ti, Ta, and Mo;
acid pickling said sintered diamond base material (1), thereby eluting 1-14% by volume of said iron family. metal or said at least one kind of carbides of W, Ti, Ta, and Mo;
forming a vapor phase synthesized diamond layer (5) on the top surface of said sintered diamond base material (1) by means of vapor phase synthesization process; and
joining the bottom surface of said sintered diamond base material (1) to a shank (7).

**10.** A method of manufacturing a hard sintered tool as recited in claim 9, wherein
said vapor phase synthesized diamond layer (5) is formed after working the top surface of said sintered diamond base material (1) so that the surface roughness (Rmax) of the top surface of said sintered diamond base material (1) becomes at most 1$\mu$m.

**11.** A method of manufacturing a hard sintered tool as recited in claim 9, further comprising working the cutting edge tip of said hard sintered tool with laser after joining the bottom surface of said sintered diamond base material (1) to said shank (7), thereby forming a cutting edge portion (6a).

**12.** A method of manufacturing a hard sintered tool as recited in claim 11, wherein
said laser is YAG laser.

**13.** A method of manufacturing a hard sintered tool as recited in claim 11, wherein
said step of forming a cutting edge portion (6a) includes a step of working the flank (9) of said hard sintered tool with said laser so that the surface roughness (Rmax) of the flank of said hard sintered tool becomes at most 0.5 $\mu$m.

**14.** A method of manufacturing a hard sintered tool as recited in claim 9, wherein
said sintered diamond base material (1) having said vapor phase synthesized diamond layer (5) formed on its top surface is joined to said shank (7) after being cut into a prescribed shape with laser.

**15.** A method of manufacturing a hard sintered tool as recited in claim 14, wherein
said laser is YAG laser.

16. A method of manufacturing a hard sintered tool as recited in claim 9, wherein
said sintered diamond base material (1) is thermally joined to said shank (7) with a brazing material containing Ag, Cu, and Ti in prescribed amounts therebetween.

17. A method of manufacturing a hard sintered tool as recited in claim 9, wherein
said vapor phase synthesized diamond layer (5) is formed by one of thermal filament chemical vapor deposition and microwave plasma chemical vapor deposition.

18. A method of manufacturing a hard sintered tool as recited in claim 9, wherein
the flank (9) of said hard sintered tool is subjected to both laser working and grinding working to form a cutting edge portion (6a).

19. A method of manufacturing a hard sintered tool as recited in claim 9, wherein
said step of acid pickling includes a step of soaking said sintered diamond base material (1) into hot aqua regia.

FIG. 1A

FIG. 1B

FIG. 2A

FIG. 2B

FIG. 3

FIG. 4

FIG. 5A

FIG. 5B

## FIG. 6

STRENGTH OF SINTERED DIAMOND

MEAN GRAIN SIZE OF DIAMOND GRAIN
INCLUDED IN THE SINTERED DIAMOND

## FIG. 7

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | EP-A-0 174 546 (SUMITOMO ELEC IND KK) 19 March 1986 <br> * example 7 * | 1-19 | C23C16/26 <br> C04B41/50 <br> B23B27/14 |
| A | PATENT ABSTRACTS OF JAPAN <br> vol. 012, no. 299 (C-520) 15 August 1988 <br> & JP-A-63 069 971 (TOSHIBA TUNGALOY CO LTD) 30 March 1988 <br> * abstract * | 1-19 | |
| A | PATENT ABSTRACTS OF JAPAN <br> vol. 017, no. 043 (M-1360) 27 January 1993 <br> & JP-A-04 261 703 (SUMITOMO ELECTRIC IND LTD) 17 September 1992 <br> * abstract * | 1-19 | |
| A | PATENT ABSTRACTS OF JAPAN <br> vol. 015, no. 202 (C-0834) 23 May 1991 <br> & JP-A-03 054 180 (SHOWA DENKO KK) 8 March 1991 <br> * abstract * | 1-19 | **TECHNICAL FIELDS SEARCHED (Int.Cl.5)** <br> C23C <br> C04B <br> B23B |
| A,D | EP-A-0 480 394 (SUMITOMO ELEC IND KK) 15 April 1992 <br> * examples 2,4 * | 1-19 | |

The present search report has been drawn up for all claims

| Place of search | Date of completion of the search | Examiner |
|---|---|---|
| THE HAGUE | 7 July 1994 | Ekhult, H |

EPO FORM 1503 03.82 (P04C01)